(19) **Europäisches Patentamt**

**European Patent Office**

**Office européen des brevets**

(11) **EP 0 762 019 B1**

(12) **EUROPEAN PATENT SPECIFICATION**

(45) Date of publication and mention
of the grant of the patent:
**17.04.2002 Bulletin 2002/16**

(51) Int Cl.7: **F16H 61/12**, G01R 31/00, H02H 7/00

(21) Application number: **96113749.4**

(22) Date of filing: **28.08.1996**

(54) **Method and apparatus for detecting an inter-terminal short circuit of a linear solenoid for an electronically controlled automatic transmission**

Verfahren und Vorrichtung zur Kurzschlusserkennung in einem linearen Elektromagnetventil für ein elektronisch gesteuertes Automatikgetriebe

Procédé et dispositif de détection de court-circuit d'une vanne électromagnétique linéaire pour boîte de vitesse automatique à commande électronique

(84) Designated Contracting States:
**DE FR GB**

(30) Priority: **08.09.1995 JP 23125795**

(43) Date of publication of application:
**12.03.1997 Bulletin 1997/11**

(73) Proprietor: **AISIN AW CO., LTD.**
**Anjo-shi Aichi-ken (JP)**

(72) Inventors:
 • **Sugiura, Masayuki**
 **Anjo-shi, Aichi-ken, 444-11 (JP)**
 • **Matsui, Shinichi**
 **Anjo-shi, Aichi-ken, 444-11 (JP)**
 • **Yoneda, Tatsuyuki**
 **Anjo-shi, Aichi-ken, 444-11 (JP)**
 • **Suzuki, Kenji**
 **Anjo-shi, Aichi-ken, 444-11 (JP)**

(74) Representative: **VOSSIUS & PARTNER**
**Siebertstrasse 4**
**81675 München (DE)**

(56) References cited:
**EP-A- 0 404 993**   **GB-A- 2 152 305**
**JP-A- 7 119 816**   **US-A- 5 202 813**
**US-A- 5 251 091**

**Description**

The present invention relates to a method of and an apparatus for detecting a linear solenoid inter-terminal short of an electronic control type automatic transmission.

When an inter-terminal short of the linear solenoid for the feedback control is to be detected in the prior art, a deviation between the quantity of inter-terminal electric quantity (or voltage) and a detected actual value is sampled, and this sampling is executed a predetermined number of times. These sampled deviations are summed up, and the inter-terminal short is judged if the total exceeds a reference value.

According to this detecting method, moreover, when the battery voltage or the power supply of the linear solenoid fluctuates, the actual value may temporarily deviate from the target value to cause the misjudgment of the inter-terminal short. In order to prevent this misjudgment, the aforementioned short detection is executed only when the fluctuation of the battery voltage is low (see e.g. JP-A-7-119 816/95).

In the aforementioned prior art, however, the detection of the inter-terminal short is executed only at the time of a small battery voltage fluctuation. The chance of the inter-terminal short detection may be limited to delay the detection of the inter-terminal short.

US-A-5 251 091 discloses a solenoid driving circuit for an automatic transmission. Said circuit prevents an excessive current from flowing to the solenoid owing to a short circuit.

The present invention contemplates to solve this problem and has the object to provide such a method of and apparatus for detecting a linear solenoid inter-terminal short of an electronic control type automatic transmission which can detect the inter-terminal short reliably even when the battery voltage fluctuates.

This object is achieved by the subject-matter defined in independent claims 1 and 5; further advantageous embodiments are defined in the dependent claims.

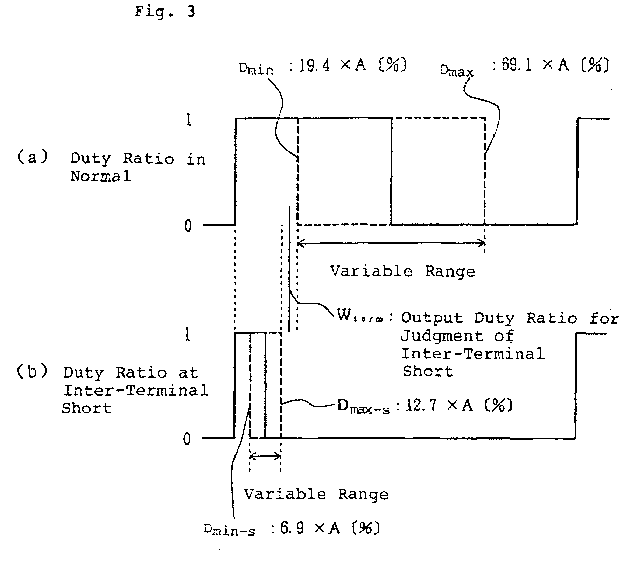

According to an embodiment of the invention, the resistance of the feedback control system excepting the resistance of the solenoid is lower than the resistance of the solenoid. Hence, there arises no overlap (as illustrated in Fig. 3) between the variable range of the set duty ratio for achieving a predetermined target value at the time of a voltage fluctuation (which may consider only the voltage with no inter-terminal short because the warranty voltage value of the control system of the automatic transmission is generally determined to fall within a predetermined range, e.g. 9 to 16 V) in the case of no inter-terminal short and the variable range of the set duty ratio for the same predetermined target value at the time of the voltage fluctuation in case of an inter-terminal short.

Without any inter-terminal short, therefore, the duty ratio to be set by the feedback control will not overlap the variable range of the duty ratio at the inter-terminal short time even if a voltage fluctuation occurs.

Noting this, the judging duty ratio is set on the basis of the set duty ratio or the target value at the inter-terminal short time, so that the inter-terminal short can be judged and detected even with the voltage fluctuation when the set duty ratio set to the target value by the feedback control becomes smaller than the judging duty ratio.

According to the invention as set forth in claims 2 and 6, the judging duty ratio is set higher than the duty ratio, which is achieved from the minimum of a battery voltage fluctuation, a resistance excepting the resistance of the linear solenoid and relating to the feedback control, and the target value of the inter-terminal electric quantity, and lower than the duty ratio which is achieved from the maximum of the battery voltage fluctuation, the resistance containing the resistance of the linear solenoid and relating to the feedback control, and the target value of the inter-terminal electric quantity. As a result, the inter-terminal short can be reliably judged.

According to the invention as set forth in claims 4 and 8, the inter-terminal short is judged when it continues for a predetermined time period or longer that the set duty ratio is lower than the judging duty ratio. As a result, it is possible to prevent the faulty detection which might otherwise accompany a delay in the feedback control or the like.

Other objects, features and advantages of the present invention will become apparent from the following description to be made with reference to the accompanying drawings, in which:

Fig. 1 is a block diagram showing an electrical circuit of an electronic control type automatic transmission to which is applied the present invention.

Fig. 2 is a circuit diagram showing an interface of a linear solenoid of the electronic control type automatic transmission.

Fig. 3 is a diagram for explaining the setting of a duty ratio and the detection of an inter-terminal short in an embodiment of the present invention.

Fig. 4 is flow chart for detecting a fault at an inter-terminal short time of a linear solenoid in accordance with the embodiment of the present invention.

Fig. 5 is a diagram showing an example of applying the present invention to a concrete hydraulic control system of the automatic transmission.

The present invention will be described in detail in connection with its mode of embodiment with reference to the accompanying drawings.

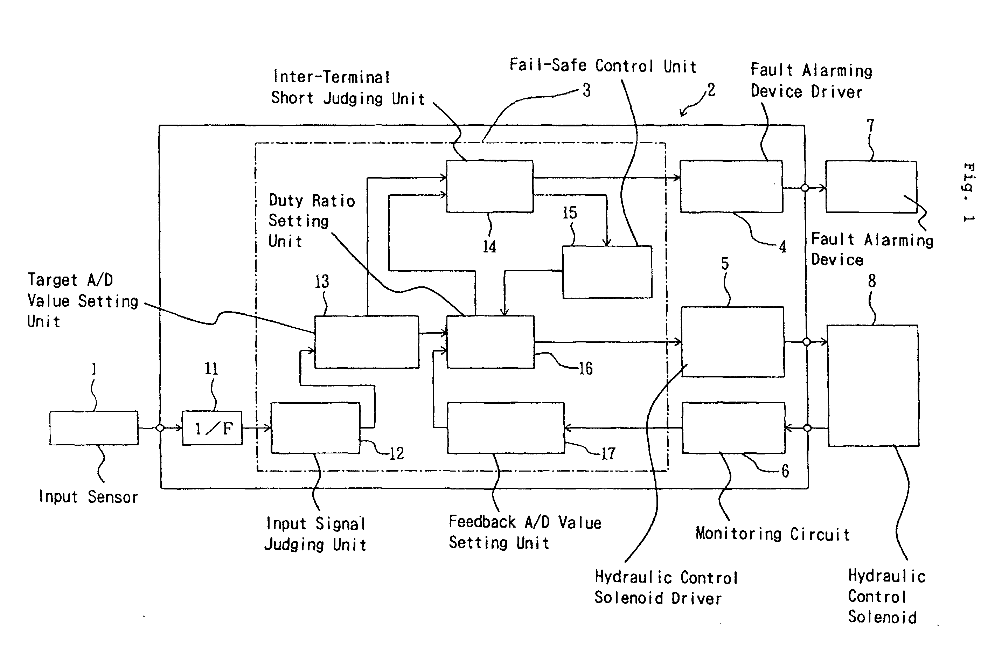

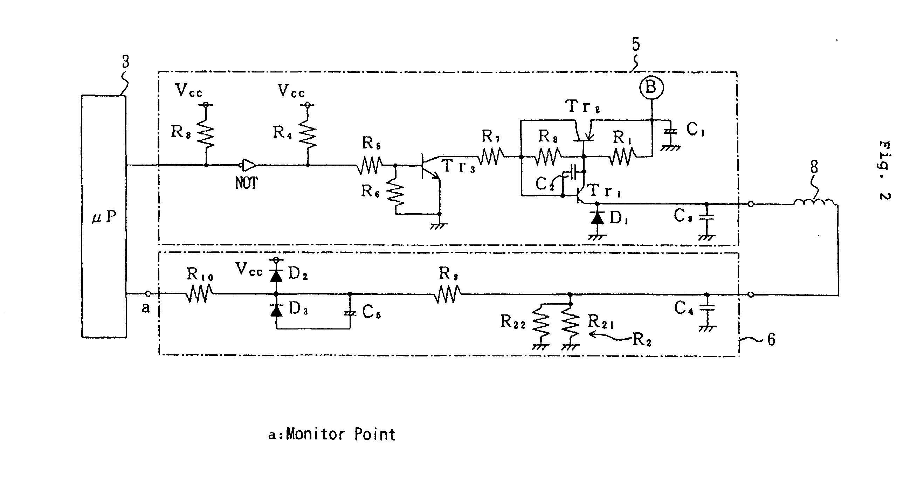

Fig. 1 is a block diagram showing an electrical circuit of an electronic control type automatic transmission to which is applied the present invention; Fig. 2 is a circuit diagram showing an interface of a linear solenoid of the transmission; and Fig. 3 is a diagram for explaining the setting of a duty ratio and the detection of an inter-terminal short in an embodiment of the present invention.

In Fig. 1: reference numeral 1 designates an input sensor composed of a throttle sensor and a vehicle speed sensor; numeral 2 an electronic control unit; and numeral 3 a microcomputer ($\mu$P). This electronic control unit 2 is composed of an interface circuit 11, an input signal judging unit 12, a target A/D value setting unit 13, an inter-terminal short judging unit 14, a fail-safe control unit 15, a duty ratio setting unit 16, a feedback A/D value setting unit 17, a fault alarming device driver 4, a hydraulic control solenoid driver 5 and a monitoring circuit 6. On the other hand, numeral 7 designates a fault alarming device whereas numeral 8 a hydraulic control solenoid, and these components are individually connected with the electronic control unit 2.

As shown in Fig. 2, on the other hand, the driver 5 of the hydraulic control solenoid 8 is composed of: a battery voltage B; a switching PNP transistor $Tr_1$; an overcurrent protecting PNP transistor $Tr_2$; an NPN transistor $Tr_3$ for receiving a signal from the microcomputer 3; capacitors $C_1$ to $C_3$; resistors $R_1$ and $R_3$ to $R_8$; a flywheel diode $D_1$; and a logical NOT circuit NOT.

On the other hand, the monitoring circuit 6 is composed of: resistors $R_2$ (i.e., a combined resistor of resistors $R_{21}$ and $R_{22}$), $R_9$ and $R_{10}$; capacitors $C_4$ and $C_5$; and diodes $D_2$ and $D_3$.

Here will be described the operations of this circuit.

First of all, when a command signal at a Low level is outputted from the microcomputer 3, it is inverted to a High level signal by the negative logic NOT circuit to raise the base potential of the NPN transistor $Tr_3$ so that this transistor $Tr_3$ is turned ON. Then, the base potential of the switching PNP transistor $Tr_1$ is lowered so that this transistor $Tr_1$ is turned ON to energize the hydraulic control solenoid 8 with the battery voltage B through the resistor $R_1$. This energization is monitored by the resistor $R_2$, and its information is read in the microcomputer 3.

On the other hand, when a command signal at the High level is outputted from the microcomputer 3, it is inverted to the Low level signal by the negative logic NOT circuit to lower the base potential of the NPN transistor $Tr_3$ so that this transistor $Tr_3$ is turned OFF. Then, the base potential of the switching PNP transistor $Tr_1$ is raised so that this transistor $Tr_1$ is turned OFF to deenergize the hydraulic control solenoid 8. This deenergization is monitored by the resistor $R_2$, and its information is read in the microcomputer 3.

Next, the control of the hydraulic control solenoid 8 will be described with reference to Fig. 1.

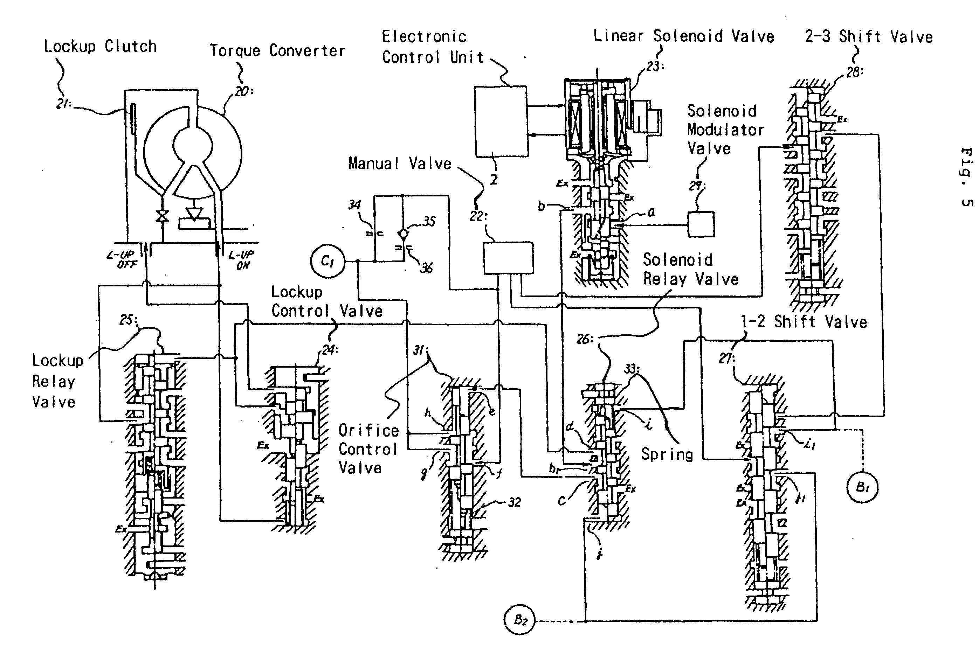

A signal such as a throttle opening signal or a vehicle speed signal, as detected by the input sensor 1, is inputted through the interface circuit 11 to the input signal judging unit 12 so that the throttle opening or the vehicle speed is judged and outputted to the target A/D value setting unit 13. On the basis of the inputted throttle opening or vehicle speed, the target A/D value setting unit 13 sets the oil pressure level to be outputted from the linear solenoid valve 23, as shown in Fig. 5, thereby to set the target A/D value (in a current value) or the target value of the quantity of electricity between the terminals of the hydraulic control solenoid 8, as corresponding to that oil pressure value.

The duty ratio setting unit 16 sets such a set duty ratio W as to reduce the difference between the target A/D value, as set in the target A/D value setting unit 13, and the feedback A/D value (in the current value), as set by the later-described feedback A/D value setting unit 17, and outputs a signal, as corresponding to the set duty ratio W, to the hydraulic control solenoid driver 5. This hydraulic control solenoid driver 5 drives the hydraulic control solenoid 8 in accordance with the signal coming from the duty ratio setting unit 16.

Moreover, the monitoring circuit 6 detects the voltage value of the monitor current detecting resistor $R_2$, as corresponds to the current value between the terminals of the hydraulic control solenoid 8, and the detected voltage value is converted by the feedback A/D value setting unit 17 into the current value between the terminals of the hydraulic control solenoid 8 and is outputted to the duty ratio setting unit 16.

Thus, the feedback control is so exercised that the quantity of electricity (in a current value) between the terminals of the hydraulic control solenoid 8 may be the target A/D value (in a current value), as set in the target A/D value setting unit 13.

Moreover, the inter-terminal short judging unit 14 judges the inter-terminal short on the basis of the target A/D value, as set by the target A/D value setting unit, and the set duty ratio as set by the duty ratio setting unit 16, as will be described hereinafter. If the inter-terminal short is judged, the inter-terminal short judging unit 14 outputs a signal to stop the output to the hydraulic control solenoid 8 and a signal to operate the fault alarming device 7 thereby to inform the operator of the fault to the fault alarming device driver 4.

Next, the method of detecting the inter-terminal short according to the present invention will be described with reference to Figs. 2 and 3.

In Fig. 2, reference letter B designates the battery voltage which fluctuates in a range of 9 to 16 V. Characters $R_1$ and $R_2$ designate the resistors which are connected in series with the hydraulic control solenoid 8, and the resistor $R_1$ is an overcurrent protecting resistor of 0.22 $\Omega \pm 5$ % whereas the resistor $R_2$ is a resistor for detecting a monitor current for the current feedback and has a resistance of $0.9\,\Omega \pm 1$ % (or a parallel circuit of $1.8\,\Omega$).

On the other hand, the dispersion of the resistance of the hydraulic control solenoid 8 itself is in a range of 2 to 5 W considering the dispersion among the products and the dispersion in the environmental temperature. Moreover, the current range for using the hydraulic control solenoid 8 is 0.3 to 1 A and need to have an ability of adjusting the current to a constant considering all the aforementioned dispersions. On the other hand, the current is adjusted through the PWM (or pulse width modulation) of 300 Hz by the microcomputer 3. Here, the duty range of the PWM for satisfying the above-specified conditions has the minimum and maximum, as illustrated in Fig. 3. That is, the duty range of the PWM in a normal state has a minimum $D_{min}$ and a maximum $D_{max}$:

$$[A/\{16/(2+0.22\times0.95+0.9\times0.99)\}]\times100 = 19.4\times A\ [\%];$$

and

$$[A/\{9/(5+0.22\times1.05+0.9\times1.01)\}]\times100 = 69.1\times A\ [\%],$$

if:

Battery Voltage: 9 to 16 [V];
Overcurrent Protecting Resistor $R_1$: 0.22 [$\Omega$] $\pm$ 5 %;
Monitor Current Detecting Resistor $R_2$: 0.9 [$\Omega$] $\pm$ 5 %;
Solenoid Resistance: 2 to 5 [$\Omega$]; and
Current Value: A [A].

Thus, the set duty ratio in a normal state ranges from $19.4\times A$ [%] to 69.1XA [%].

On the other hand, the duty range of the PWM at the time of an inter-terminal short has a minimum $D_{min-S}$ and a maximum $D_{max-S}$:

$$[A/\{16/(0.22\times0.95+0.9\times0.99)\}]\times100 = 6.9\times A\ [\%];$$

and

$$[A/\{9/(0.22\times1.05+0.9\times1.01)\}]\times100 = 12.7\times A\ [\%].$$

Thus, the set duty ratio at the inter-terminal short time ranges from $6.9\times A$ [%] to $12.7\times A$ [%].

In the present embodiment, therefore, the judging duty ratio is set between the range ($6.9\times A$ [%]) to $12.7\times A$ [%]) of the set duty ratio in the normal state and the range ($19.4\times A$ [%] to $69.1\times A$ [%]) of the set duty ratio at the inter-terminal short time.

The hydraulic control solenoid 8 controls the output oil pressure of a linear solenoid valve 23 of Fig. 5 to 0.5 to 4.5 $Kg/cm^2$ between the current value of 1 to 0.3 A, as outputted from the electronic control unit 2, on the basis of the information of the input sensor 1 such as throttle opening and the vehicle speed, thereby to control an orifice control valve 31, a lockup control valve 24 and the a lockup relay valve 25.

The driver 5 and the monitoring circuit 6 for the hydraulic control solenoid 8 are shown in Fig. 2 and constitute a current feedback control so as to correct the aforementioned dispersions (including the dispersion of the battery voltage and the dispersion of the resistance of the solenoid) due to the external causes. Hence, both the + and - terminals of the hydraulic control solenoid 8 are connected with the electronic control unit 2.

If these + and - terminals of the hydraulic control solenoid 8 are shorted, the current to flow through the solenoid 8 reduces to zero so that the output oil pressure takes a value of 5 $Kg/cm^2$ over the normal maximum pressure. This makes it necessary to detect the inter-terminal short fault reliably thereby to control the fail-safe and warn the fault.

Here, when both the + and - terminals of the hydraulic control solenoid (or linear solenoid) 8 are shorted, the resistance of the feedback control system excepting the resistance of the solenoid is lower than that of the solenoid, as described above. Hence, there arises no overlap (as illustrated in Fig. 3) between the variable range of the set duty ratio for achieving a predetermined target value at the time of a voltage fluctuation (which may consider only the voltage with no inter-terminal short because the warranty voltage value of the control system of the automatic transmission is generally determined to be in the range of 9 to 16 V) in the case of no inter-terminal short and the variable range of the set duty ratio for the same predetermined target value at the time of the voltage fluctuation in case of an inter-terminal short.

Without any inter-terminal short, therefore, the duty ratio to be set by the feedback control will not overlap the variable range of the duty ratio at the inter-terminal short time even if a voltage fluctuation occurs (as illustrated in Fig. 3(a)).

Noting this, the judging duty ratio is set on the basis of the set duty ratio or the target value at the inter-terminal short time, so that the inter-terminal short can be judged and detected even with the voltage fluctuation when the set duty ratio set to the target value by the feedback control becomes smaller than the judging duty ratio (as illustrated in Fig. 3(b)).

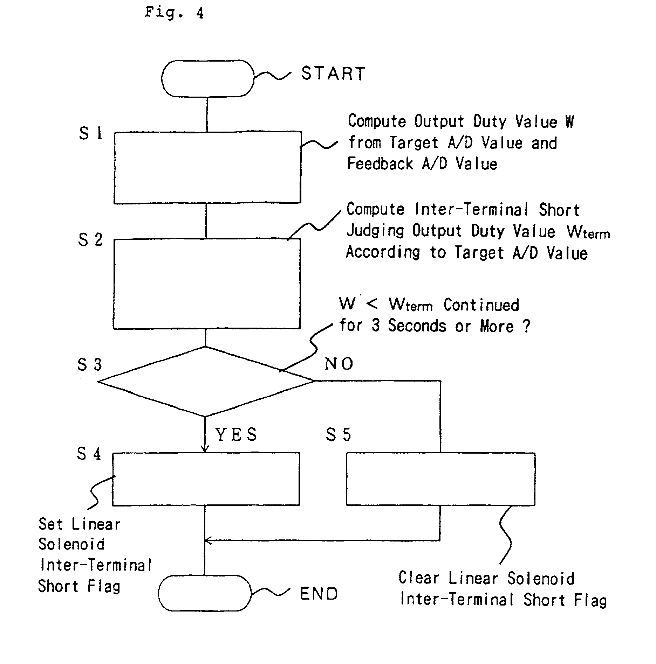

With reference to Fig. 4, here will be described a fault detecting procedure at the time of an inter-terminal short time of the linear solenoid.

(1) First of all, the output duty value (or set duty value) is computed (at Step S1) from the A/D value (as will be called the "target A/D value") or the target value of the quantity of inter-terminal electricity and the A/D value (as will be called the "feedback A/D value") to be fed back. This step is executed in the duty ratio setting unit 16.
(2) Next, the inter-terminal short judging output duty value $W_{term}$ according to the target A/D value is computed (at Step S2). This step is executed in the inter-terminal short judging unit 14. The inter-terminal short judging output duty value $W_{term}$ is set to a value between the duty range in the normal state and the duty range at the inter-terminal short time, as described before. Since, however, this judging output duty value $W_{term}$ is different depending upon the target A/D value, the judging output duty value $W_{term}$ corresponding to the target A/D value is computed.
(3) Next, it is judged (at Step S3) whether or not it continues for three seconds or more that the output duty value W (or set duty value) is smaller than the inter-terminal short judging output duty value $W_{term}$. This step is also executed in the inter-terminal short judging unit 14.
(4) If the answer of Step S3 is YES, a linear solenoid inter-terminal short flag is set (at Step S4). If the answer is NO, on the other hand, the linear solenoid inter-terminal short flag is cleared (at Step S5). This step is also executed in the inter-terminal short judging unit 14.

Thus, the inter-terminal short can be detected by checking the operations of Steps S1 to S5.

Fig. 5 is a diagram showing an example of applying the present invention to a concrete hydraulic control system of an automatic transmission.

As shown in Fig. 5, the oil pressure, as finely adjusted by the linear solenoid valve 23, is fed for adjusting the valve position of the orifice control valve 31. Specifically, a solenoid modulator valve 29 receives the oil pressure regulated by the (not-shown) primary regulator valve and modulates it for the individual solenoids. The oil pressure, as modulated by the solenoid modulator valve 29, is fed to a port a of the linear solenoid valve 23. This linear solenoid valve 23 is linearly controlled by a signal, as fed from the not-shown control unit, to adjust the oil pressure fed to the port a and feed it to a port b.

Subsequently, the oil pressure from the port b is fed to a port $b_1$ of a solenoid relay valve 26. This solenoid relay valve 26 is enabled to take two positions of righthand half and lefthand half positions. In the righthand half position, the aforementioned port $b_1$ is connected to a port c to feed the oil pressure to a port e at one end of the orifice control valve 31. In the lefthand half position, on the other hand, the port $b_1$ is connected to a port d so that the oil pressure adjusted finely by the solenoid relay valve 26 is fed to a lockup operation unit and used to turn ON/OFF the lockup.

The aforementioned orifice control valve 31 is adjusted in its valve position by the balance between the oil pressure, as finely adjusted by the linear solenoid valve 23 and fed to the port e, and the biasing force of a spring 32. Moreover, the oil pressure from the manual valve 22 is fed via a port f to the orifice control valve 31 and sent in the lefthand half position via a port g and in the righthand half position via ports g and h to a forward clutch $C_1$.

As a result, when the valve member of the orifice control valve 31 gradually moves down as it is fed with the oil pressure from the aforementioned linear solenoid valve 23, a little oil is sent at first via the port g and a lot of oil is sent later via the ports g and h to the forward clutch $C_1$ so that the shifting shock is reduced.

Incidentally, the oil from the manual valve 22 is fed not only through the orifice control valve 31 but also a throttle 34 and a throttle 36 having a check valve 35 to the forward clutch $C_1$. By the action of the throttle 36 having the check valve 35, the oil flow to the forward clutch $C_1$ can be made more at a drain time than that at the feed time.

Incidentally, the solenoid relay valve 26 distributes the oil pressure from the linear solenoid valve 23 either for adjusting the valve position of the orifice control valve 31 or for controlling the lockup operation unit and takes two positions, i.e., the righthand half and lefthand half positions for that distribution. For this, the oil pressure for applying a second coast brake $B_1$ is fed to a port i at one end of the solenoid relay valve 26 from a port $i_1$ of a 1-2 shift valve 27, and an oil pressure for applying a second brake $B_2$ is fed to a port j at the other end of the solenoid relay valve 26 from a port $j_1$ of the 1-2 shift valve 27. On the valve end face at the side of the aforementioned port i, moreover, there is arranged a spring 33 for urging the valve downward.

Here at the 1st speed of D, 2nd and L ranges, neither the second coast brake $B_1$ nor the second brake $B_2$ is applied to feed no oil pressure to the ports i and j so that the aforementioned solenoid relay valve 26 is held in the righthand half position exclusively by the urging force of the spring 33.

Next at the 2nd or higher speed of the D, 2nd and L ranges, the second brake $B_2$ is applied to feed the oil pressure to the port j. At the 2nd speed of the 2nd and L ranges, not only the second brake $B_2$ but also the second coast brake $B_1$ is applied to feed the oil pressure to the port i, too. Incidentally, when both the ports i and j are fed with the oil pressures, these oil pressures are fed from a manual valve 22 through the 1-2 shift valve 27 or a 2-3 shift valve 28. These pressures are at the same level to push the two end faces of the solenoid relay valve 26 by the equal forces. As a result, the solenoid relay valve 26 is caused to take the righthand half position exclusively by the urging force of the spring 33.

Specifically, when a shift is made from each of the N, R and P ranges to the 1st speed of the D, 2nd and L ranges, the solenoid relay valve 26 always takes the righthand half position so that it can feed the oil pressure of the linear solenoid valve 23 to the orifice control valve 31 to reduce the shift shock.

When a 2nd or higher speed of the D, 2nd and L ranges is taken, on the other hand, the lockup mechanism need to be operated. As a result, the solenoid relay valve 26 takes the lefthand half position to feed the oil pressure of the linear solenoid valve 23 to the lockup control valve 24 and the lockup relay valve 25. Incidentally, the lockup has to be released for starting the 2nd speed of the 2nd range. Since, however, the solenoid relay valve 26 is caused at the 2nd speed of the 2nd and L ranges to take the righthand half position exclusively by the urging force of the spring 33, as described above, the oil pressure of the linear solenoid valve 23 is fed to neither the lockup control valve 24 nor the lockup relay valve 25.

In the hydraulic control system with a method/an apparatus constructed according to the present invention, the solenoid of the aforementioned linear solenoid valve 23 is driven by connecting the electronic control unit 2 with it. As a result, the short fault between the terminals of the solenoid of the linear solenoid valve 23 can be reliably detected independently of the voltage fluctuation of the battery. Incidentally, in Fig. 5, reference numeral 20 designates a torque converter, and numeral 21 designates a lockup clutch.

Since the occurrence of the short fault is stored in the memory of the electronic control unit 2, moreover, the faulty portion can be promptly located by reading it in a dealer or the like by a diagnosis tester or the like, to improve the serviceability.

**Claims**

1. A method of detecting an inter-terminal short of a linear solenoid (8) of an electronic control type automatic transmission, wherein the linear solenoid (8) is to be driven on the basis of a set duty ratio (W) set by a feedback control so that an inter-terminal electric quantity may achieve a predetermined target value, **characterized by**:

   setting a judging duty ratio ($W_{term}$) corresponding to said predetermined target value;
   comparing said judging duty ratio ($W_{term}$) and said set duty ratio (W); and
   judging that said inter-terminal short occurs, when said set duty ratio (W) is smaller than said judging duty ratio ($W_{term}$).

2. A method as set forth in claim 1, wherein said judging duty ratio ($W_{term}$) is set higher than the set duty ratio (W), which is achieved from the minimum of a battery voltage fluctuation, a resistance excepting the resistance of said linear solenoid (8) and relating to the feedback control, and the target value of the inter-terminal electric quantity, and lower than the duty ratio which is achieved from the maximum of the battery voltage fluctuation, the resistance containing the resistance of said linear solenoid and relating to the feedback control, and the target value of said interterminal electric quantity.

3. A method as set forth in claim 1, wherein said judging duty ratio ($W_{term}$) is set higher than the set duty ratio (W) for said inter-terminal electric quantity to become said target value by the feedback control at the time of inter-terminal short, and lower than the duty ratio (W) for said inter-terminal electric quantity to become said target value by the feedback control in a normal state.

4. A method as set forth in claim 1, 2, or 3, wherein said inter-terminal short is judged when it continues for a predetermined time period or longer that said set duty ratio (W) is lower than said judging duty ratio ($W_{term}$).

5. An apparatus for detecting an inter-terminal short of a linear solenoid (8) of an electronic control type automatic transmission, wherein the linear solenoid (8) is to be driven on the basis of a set duty ratio (W) set by a feedback control so that an inter-terminal electric quantity may achieve a predetermined target value, **characterized by**:

means (14) setting a judging duty ratio ($W_{term}$) corresponding to said predetermined target value;
means (14) comparing said judging duty ratio ($W_{term}$) and said set duty ratio (W); and
means (14) judging that said inter-terminal short occurs, when said set duty ratio (W) is smaller than said judging duty ratio ($W_{term}$).

**6.** An apparatus as set forth in claim 5, wherein said judging duty ratio ($W_{term}$) is set higher than the set duty ratio (W), which is achieved from the minimum of a battery voltage fluctuation, a resistance excepting the resistance of said linear solenoid and relating to the feedback control, and the target value of the inter-terminal electric quantity, and lower than the duty ratio (W) which is achieved from the maximum of the battery voltage fluctuation, the resistance containing the resistance of said linear solenoid and relating to the feedback control, and the target value of said inter-terminal electric quantity.

**7.** An apparatus as set forth in claim 4, wherein said judging duty ratio ($W_{term}$) is set higher than the set duty ratio (W) for said inter-terminal electric quantity to become said target value by the feedback control at the time of inter-terminal short, and lower than the duty ratio (W) for said inter-terminal electric quantity to become said target value by the feedback control in a normal state.

**8.** An apparatus as set forth in claim 4 or 5, wherein said inter-terminal short is judged when it continues for a predetermined time period or longer that said set duty ratio (W) is lower than said judging duty ratio ($W_{term}$).

**Patentansprüche**

**1.** Verfahren zum Erkennen eines zwischen Anschlüssen eines linearen Elektromagnets (8) auftretenden Kurzschlusses bei einem elektronisch gesteuerten Automatikgetriebe, wobei der lineare Elektromagnet (8) auf der Grundlage eines von einer Rückkopplungssteuerung eingestellten Einschaltverhältnisses (W) so anzusteuern ist, daß eine zwischen Anschlüssen auftretende elektrische Größe einen vorbestimmten Zielwert annehmen kann, **gekennzeichnet durch**:

Einstellen eines dem vorbestimmten Zielwert entsprechenden Beurteilungs-Einschaltverhältnisses ($W_{term}$),
Vergleichen des Beurteilungs-Einschaltverhältnisses ($W_{term}$) mit dem eingestellten Einschaltverhältnis (W) und
Urteilen, daß der Kurzschluß zwischen Anschlüssen auftritt, wenn das eingestellte Einschaltverhältnis (W) kleiner ist als das Beurteilungs-Einschaltverhältnis ($W_{term}$).

**2.** Verfahren nach Anspruch 1, wobei das Beurteilungs-Einschaltverhältnis ($W_{term}$) auf einen höheren Wert gelegt wird als das eingestellte Einschaltverhältnis (W), das anhand des Minimums einer Batteriespannungsschwankung, eines den Widerstand des linearen Elektromagneten (8) nicht enthaltenden Widerstands, der sich auf die Rückkopplungssteuerung bezieht, und des Zielwerts der zwischen Anschlüssen auftretenden elektrischen Größe erreicht wird, und auf einen niedrigeren Wert gelegt wird als das Einschaltverhältnis, das anhand des Maximums der Batteriespannungsschwankung, des den Widerstand des linearen Elektromagneten (8) enthaltenden Widerstands, der sich auf die Rückkopplungssteuerung bezieht, und des Zielwerts der zwischen Anschlüssen auftretenden elektrischen Größe erreicht wird.

**3.** Verfahren nach Anspruch 1, wobei das Beurteilungs-Einschaltverhältnis ($W_{term}$) auf einen höheren Wert gelegt wird als das eingestellte Einschaltverhältnis (W) für die zwischen Anschlüssen auftretende elektrische Größe, so daß es während eines zwischen Anschlüssen auftretenden Kurzschlusses durch die Rückkopplungssteuerung zu dem Zielwert wird, und auf einen niedrigeren Wert gelegt wird als das Einschaltverhältnis (W) für die zwischen Anschlüssen auftretende elektrische Größe, so daß es in einem Normalzustand durch die Rückkopplungssteuerung zu dem Zielwert wird.

**4.** Verfahren nach Anspruch 1, 2 oder 3, wobei geurteilt wird, daß zwischen Anschlüssen ein Kurzschluß auftritt, wenn das eingestellte Einschaltverhältnis (W) über einen vorbestimmten Zeitraum oder länger niedriger bleibt als das Beurteilungs-Einschaltverhältnis ($W_{term}$).

**5.** Vorrichtung zum Erkennen eines zwischen Anschlüssen eines linearen Elektromagneten (8) auftretenden Kurzschlusses bei einem elektronisch gesteuerten Automatikgetriebe, wobei der lineare Elektromagnet (8) auf der Grundlage eines von einer Rückkopplungssteuerung eingestellten Einschaltverhältnisses (W) so anzusteuern ist, daß eine zwischen Anschlüssen auftretende elektrische Größe einen vorbestimmten Zielwert annehmen kann, **gekennzeichnet durch**:

eine Einrichtung (14) zum Einstellen eines dem vorbestimmten Zielwert entsprechenden Beurteilungs-Einschaltverhältnisses ($W_{term}$),
eine Einrichtung (14) zum Vergleichen des Beurteilungs-Einschaltverhältnisses ($W_{term}$) mit dem eingestellten Einschaltverhältnis (W) und
eine Einrichtung (14) zum Urteilen, daß der Kurzschluß zwischen Anschlüssen auftritt, wenn das eingestellte Einschaltverhältnis (W) kleiner ist als das Beurteilungs-Einschaltverhältnis ($W_{term}$).

6. Vorrichtung nach Anspruch 5, wobei das Beurteilungs-Einschaltverhältnis ($W_{term}$) auf einen höheren Wert gelegt wird als das eingestellte Einschaltverhältnis (W), das anhand des Minimums einer Batteriespannungsschwankung, eines den Widerstand des linearen Elektromagneten (8) nicht enthaltenden Widerstands, der sich auf die Rückkopplungssteuerung bezieht, und des Zielwerts der zwischen Anschlüssen auftretenden elektrischen Größe erreicht wird, und auf einen niedrigeren Wert gelegt wird als das Einschaltverhältnis (W), das anhand des Maximums der Batteriespannungsschwankung, des den Widerstand des linearen Elektromagneten (8) enthaltenden Widerstands, der sich auf die Rückkopplungssteuerung bezieht, und des Zielwerts der zwischen Anschlüssen auftretenden elektrischen Größe erreicht wird.

7. Vorrichtung nach Anspruch 4, wobei das Beurteilungs-Einschaltverhältnis ($W_{term}$) auf einen höheren Wert gelegt wird als das eingestellte Einschaltverhältnis (W) für die zwischen Anschlüssen auftretende elektrische Größe, so daß es während eines zwischen Anschlüssen auftretenden Kurzschlusses durch die Rückkopplungssteuerung zu dem Zielwert wird, und auf einen-- niedrigeren Wert gelegt wird als das Einschaltverhältnis (W) für die zwischen Anschlüssen auftretende elektrische Größe, so daß es in einem Normalzustand durch die Rückkopplungssteuerung zu dem Zielwert wird.

8. Vorrichtung nach Anspruch 4 oder 5, wobei geurteilt wird, daß zwischen Anschlüssen ein Kurzschluß auftritt, wenn das eingestellte Einschaltverhältnis (W) über einen vorbestimmten Zeitraum oder länger niedriger bleibt als das Beurteilungs-Einschaltverhältnis ($W_{term}$).

**Revendications**

1. Procédé de détection d'un court-circuit entre bornes d'un solénoïde linéaire (8) d'une transmission automatique du type à commande électronique, selon lequel le solénoïde linéaire (8) doit être attaqué sur la base d'un taux de charge réglé (W) établi par une commande à rétroaction de telle façon qu'une quantité électrique entre bornes puisse atteindre une valeur cible prédéterminée, **caractérisé par** :

- l'établissement d'un taux de charge d'estimation (Wterm) correspondant à ladite valeur cible prédéterminée ;

- la comparaison dudit taux de charge d'estimation (Wterm) et dudit taux de charge réglé (W) ; et

- la détermination de l'apparition dudit court-circuit entre bornes lorsque ledit taux de charge réglé (W) est inférieur audit taux de charge d'estimation (Wterm).

2. Procédé selon la revendication 1, selon lequel ledit taux de charge d'estimation (Wterm) est pris supérieur au taux de charge réglé (W) qui est obtenu à partir du minimum d'une variation de tension de batterie, d'une résistance à l'exception de la résistance dudit solénoïde linéaire (8) et liée à la commande à rétroaction, et de la valeur cible de la quantité électrique entre bornes, et inférieur au taux de charge qui est obtenu à partir du maximum de la variation de tension de batterie, de la résistance contenant la résistance dudit solénoïde linéaire et liée à la commande à rétroaction, et de la valeur cible de ladite quantité électrique entre bornes.

3. Procédé selon la revendication 1, selon lequel ledit taux de charge d'estimation (Wterm) est pris supérieur audit taux de charge réglé (W) pour ladite quantité électrique entre bornes afin d'atteindre ladite valeur cible à l'aide de la commande à rétroaction au moment d'un court-circuit entre bornes, et inférieur au taux de charge (W) pour ladite quantité électrique entre bornes afin de devenir ladite valeur cible à l'aide de la commande à rétroaction dans un état normal.

4. Procédé selon la revendication 1, 2 ou 3, selon lequel ledit court-circuit entre bornes est établi lorsqu'il se poursuit pendant une période de temps prédéterminée ou plus longtemps si ledit taux de charge réglé (W) est inférieur audit taux de charge d'estimation (Wterm).

5. Dispositif pour la détection d'un court-circuit entre bornes d'un solénoïde linéaire (8) d'une transmission automatique du type à commande électronique, selon lequel le solénoïde linéaire (8) doit être attaqué sur la base d'un taux de charge réglé (W) établi par une commande à rétroaction de telle façon qu'une quantité électrique entre bornes puisse atteindre une valeur cible prédéterminée, **caractérisé par** :

   - un moyen (14) pour l'établissement d'un taux de charge d'estimation (Wterm) correspondant à ladite valeur cible prédéterminée ;

   - un moyen (14) pour la comparaison dudit taux de charge d'estimation (Wterm) et dudit taux de charge réglé (W) ; et

   - un moyen (14) pour la détermination de l'apparition dudit court-circuit entre bornes lorsque ledit taux de charge réglé (W) est inférieur audit taux de charge d'estimation (Wterm).

6. Dispositif selon la revendication 5, dans lequel ledit taux de charge d'estimation (Wterm) est pris supérieur au taux de charge réglé (W) qui est obtenu à partir du minimum d'une variation de tension de batterie, d'une résistance à l'exception de la résistance dudit solénoïde linéaire et liée à la commande à rétroaction, et de la valeur cible de la quantité électrique entre bornes, et inférieur au taux de charge (W) qui est obtenu à partir du maximum de la variation de tension de batterie, de la résistance contenant la résistance dudit solénoïde linéaire et liée à la commande à rétroaction, et de la valeur cible de ladite quantité électrique entre bornes.

7. Dispositif selon la revendication 4, dans lequel ledit taux de charge d'estimation (Wterm) est pris supérieur audit taux de charge réglé (W) pour ladite quantité électrique entre bornes afin d'atteindre ladite valeur cible à l'aide de la commande à rétroaction au moment d'un court-circuit entre bornes, et inférieur au taux de charge (W) pour ladite quantité électrique entre bornes afin de devenir ladite valeur cible à l'aide de la commande à rétroaction dans un état normal.

8. Dispositif selon la revendication 4 ou 5, dans lequel ledit court-circuit entre bornes est déterminé lorsqu'il se poursuit pendant une période de temps prédéterminée ou plus longtemps si ledit taux de charge réglé (W) est inférieur audit taux de charge d'estimation (Wterm).

Fig. 1

Fault Alarming Device Driver

7

Fault Alarming Device

8

Hydraulic Control Solenoid

Monitoring Circuit

4

2

5

6

Fail-Safe Control Unit

Hydraulic Control Solenoid Driver

3

Feedback A/D Value Setting Unit

15

14

16

17

Inter-Terminal Short Judging Unit

Duty Ratio Setting Unit

13

12

Input Signal Judging Unit

11

1/F

Target A/D Value Setting Unit

1

Input Sensor

Fig. 2

a:Monitor Point

Fig. 3

(a) Duty Ratio in Normal

$D_{min}$ : 19.4 ×A [%]  $D_{max}$ : 69.1 ×A [%]

Variable Range

$W_{i\cdot r\cdot m}$ : Output Duty Ratio for Judgment of Inter-Terminal Short

(b) Duty Ratio at Inter-Terminal Short

$D_{max-s}$ : 12.7 ×A [%]

Variable Range

$D_{min-s}$ : 6.9 ×A [%]

Fig. 4

START

S1 — Compute Output Duty Value W from Target A/D Value and Feedback A/D Value

S2 — Compute Inter-Terminal Short Judging Output Duty Value W_term According to Target A/D Value

S3 — W < W_term Continued for 3 Seconds or More ?   NO

YES   S5

S4 — Set Linear Solenoid Inter-Terminal Short Flag

Clear Linear Solenoid Inter-Terminal Short Flag

END

Fig. 5